(19) Europäisches Patentamt / European Patent Office / Office européen des brevets

(11) **EP 2 101 413 A1**

(12) **DEMANDE DE BREVET EUROPEEN**

(43) Date de publication:
**16.09.2009 Bulletin 2009/38**

(51) Int Cl.:
***H03L 1/02*** (2006.01)

(21) Numéro de dépôt: **08152548.7**

(22) Date de dépôt: **10.03.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(71) Demandeur: **CSEM Centre Suisse d'Electronique et de Microtechnique SA - Recherche et Développement 2002 Neuchâtel (CH)**

(72) Inventeur: **Ruffieux, David 1789, Lugnorre (CH)**

(74) Mandataire: **GLN Rue du Puits-Godet 8a 2000 Neuchâtel (CH)**

(54) **Dispositif et methode de compensation thermique d'un resonateur**

(57) L'invention concerne un dispositif apte à compenser la dérive en température d'une fréquence de référence d'un résonateur piézoélectrique de type silicium (27) comprenant :

- un capteur de température (21) apte à mesurer une température de fonctionnement dudit résonateur (27) et apte à fournir un premier signal correspondant à la température,
- un séquenceur (22) relié audit capteur de température (21), ledit séquenceur (22) étant apte à déterminer un deuxième signal de compensation, à partir du premier signal et en fonction de la valeur de ladite température, au moyen de données de calibration destinées à être stockées dans un moyen de stockage (24) relié audit séquenceur (22), ledit deuxième signal correspondant à une valeur positive N, ledit séquenceur (22) étant, en outre, apte à déterminer un troisième signal de compensation, à partir dudit premier signal et en fonction de la valeur de ladite température, au moyen des données de calibration, ledit troisième signal correspondant à un rapport entre un entier positif S et N, S étant inférieur ou égal à N.

Selon l'invention, le dispositif comprend un compteur variable (26) relié audit séquenceur (22) et relié à un oscillateur (10) muni dudit résonateur (27), ledit compteur variable (26) étant apte à recevoir lesdits signaux compensés, apte à produire un quatrième signal de sortie chaque N périodes d'un signal d'horloge provenant dudit résonateur (27), et apte à détecter l'état S, agencé pour produire un cinquième signal apte à modifier la capacité de charge dudit oscillateur (10).

Fig. 2

EP 2 101 413 A1

**Description**

Domaine technique

La présente invention se rapporte au domaine des dispositifs de compensation thermique des résonateurs piézoélectriques ou électrostatiques agencés dans des oscillateurs.

Elle concerne plus particulièrement un dispositif électronique permettant de compenser la dérive thermique de la fréquence d'un résonateur piézoélectrique ou électrostatique en silicium dans un but d'assurer la stabilité de sa fréquence de référence.

Etat de la technique

L'article de D. Lanfranchi et al., « A Microprocessor-Based Analog Wristwatch Chip with 3 Seconds/Year Accuracy », IEEE 1994, décrit un circuit permettant d'augmenter la stabilité de la fréquence nominale d'un résonateur de type quartz horloger typiquement de fréquence égale à 32 kHz. Un oscillateur est associé à ce résonateur. Il est prévu un fonctionnement en mode bi-fréquentiel de l'oscillateur : l'ajustement en fréquence est effectué en procédant à une commutation d'une capacité ajoutée à la structure de l'oscillateur, par un signal de référence externe. Ainsi l'oscillateur, qualifié de bi-fréquence, peut osciller à deux fréquences différentes : une première fréquence supérieure à la fréquence nominale et une seconde fréquence inférieure à la fréquence nominale. Il peut être défini un ratio entre les temps moyens respectifs que l'oscillateur passe aux deux fréquences haute et basse, correspondant respectivement à la première fréquence supérieure et à la seconde fréquence inférieure. L'ajustement de ce ratio est effectué au moyen d'un signal de référence. Ce signal de référence peut dériver soit d'un deuxième résonateur plus précis, soit d'un capteur de température. Le résonateur plus précis peut être utilisé de façon intermittente. Toutefois, il consomme trop pour jouer le rôle d'une base de temps servant à maintenir une horloge temps réel, appelée RTC (« Real Time Clock »). De plus, le recours à deux résonateurs n'est pas compatible avec un souci de miniaturisation maximale des dispositifs électroniques.

Il peut donc être préférable d'obtenir la base de temps en intégrant un résonateur à basse fréquence de type silicium, combiné à un capteur de température. Ce résonateur permet à la fois de générer une fréquence de référence et une base de temps, en conservant une consommation raisonnable. La fréquence est comprise entre 10 kHz et 2 MHz et, préférentiellement entre 30 kHz et 1 MHz. Le capteur de température doit alors être utilisé en boucle ouverte, ce qui nécessite une calibration a priori et à plusieurs températures à la fois du capteur de température et de l'oscillateur associé au résonateur à basse fréquence.

Or, un dispositif dit de mode bi-fréquence ne permet de compenser les variations de la fréquence du résonateur en fonction de la température que sur une échelle correspondant à la différence dite de tirage entre la fréquence haute et la fréquence basse. La variation de la fréquence d'un résonateur silicium, en fonction de la température, est proche de 30 parties par million (ppm) par degré Celsius. Il a été montré que l'on pouvait obtenir un tirage de l'ordre de 100 ppm pour un résonateur de ce type. Le résonateur de type silicium ne peut alors être compensé que sur une gamme d'environ 3 degrés Celsius, ce qui est insuffisant pour une application industrielle.

Divulgation de l'invention

Un objet de la présente invention est de fournir un dispositif permettant de générer une fréquence compensée stable sur une gamme de température étendue à partir d'un résonateur piézoélectrique de type silicium.

Un autre objet de la présente invention est de prévoir un procédé de compensation thermique électronique de la fréquence de référence d'un résonateur piézoélectrique de type silicium.

Plus particulièrement, l'invention concerne un dispositif apte à compenser la dérive en température d'une fréquence de référence d'un résonateur piézoélectrique de type silicium. Le dispositif comprend :

- un capteur de température apte à mesurer une température de fonctionnement du résonateur et apte à fournir un premier signal correspondant à la température,
- un séquenceur relié au capteur de température, le séquenceur étant apte à déterminer un deuxième signal de compensation, à partir du premier signal et en fonction de la valeur de la température, au moyen de données de calibration destinées à être stockées dans un moyen de stockage relié au séquenceur, le deuxième signal correspondant à une valeur positive N, le séquenceur étant, en outre, apte à déterminer un troisième signal de compensation, à partir du premier signal et en fonction de la valeur de la température, au moyen des données de calibration destinées à être stockées dans le moyen de stockage relié au séquenceur, le troisième signal correspondant à un rapport entre un entier positif S et N, S étant inférieur ou égal à N.

Selon l'invention, le dispositif comprend également un compteur variable relié au séquenceur et relié à un oscillateur muni du résonateur. Le compteur variable est apte à recevoir les signaux de compensation, et apte à produire un quatrième signal de sortie chaque N périodes d'un signal d'horloge provenant du résonateur, et apte à détecter l'état S, agencé pour produire un cinquième signal apte à modifier la capacité de charge de l'oscillateur.

L'invention concerne également un procédé de compensation de la dérive en température d'une fréquence de référence d'un résonateur piézoélectrique de type silicium comprenant les étapes suivantes :

- mise en fonctionnement d'un capteur de température par un séquenceur reliée audit capteur,
- lecture d'un premier signal correspondant à une mesure de température de fonctionnement du résonateur, le premier signal étant issu du capteur de température,
- détermination d'un deuxième signal de compensation à partir du premier signal par le séquenceur au moyen de données de calibration stockées dans un moyen de stockage relié au séquenceur, le deuxième signal correspondant à une valeur positive N,
- détermination d'un troisième signal de compensation à partir du premier signal par le séquenceur au moyen des données de calibration, le troisième signal correspondant à un rapport entre un entier positif S et N, S étant inférieur ou égal à N,
- réception des signaux compensés par un compteur variable relié au séquenceur et à un oscillateur muni du résonateur,
- production d'un quatrième signal de sortie par le compteur variable chaque N périodes d'un signal d'horloge provenant du résonateur,
- détection de l'état S inférieur ou égal à N, dans le but de produire un cinquième signal apte à modifier la capacité de charge dudit oscillateur.

Brève description des dessins

D'autres caractéristiques de la présente invention apparaîtront plus clairement à la lecture de la description qui va suivre, faite en référence au dessin annexé, dans lequel:

- la figure 1 représente une structure d'oscillateur classiquement utilisée en association avec un résonateur ;
- la figure 2 représente un dispositif de compensation d'un premier mode de réalisation selon la présente invention ;
- la figure 3 représente un dispositif de compensation d'un deuxième mode de réalisation selon la présente invention.

Mode(s) de réalisation de l'invention

Par souci de clarté, de mêmes éléments ont été désignés par les mêmes références dans les différentes figures.

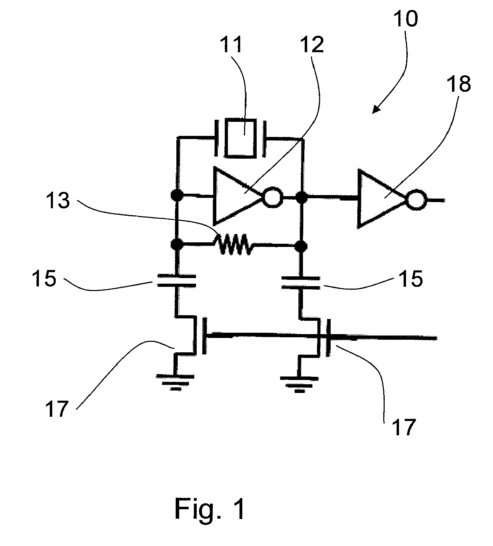

Sur la figure 1 est représenté un exemple d'oscillateur 10 associé à un résonateur 11 piézoélectrique. L'oscillateur 10 comprend un premier inverseur 12 placé entre les noeuds du résonateur 11 et une résistance de polarisation 13 connectée aux bornes de l'oscillateur 10. Dans le cadre d'un mode bi-fréquence, l'oscillateur est connecté à un banc d'une ou de deux capacités 15 commutables : chacune des deux capacités 15 est reliée à la masse par un interrupteur pouvant être un transistor 17 de type MOS. Si l'oscillateur 10 est utilisé comme une sortie d'une base de temps pour le maintien d'une horloge temps réel, un deuxième inverseur 18 identique au premier inverseur 12 est connecté audit oscillateur 10.

La fréquence d'oscillation de l'oscillateur 10 peut être rendue variable en ajustant la capacité de charge au moyen des capacités 15 commutables. En mode bi-fréquence, on parle de différence de tirage. Le décalage de fréquence entre la fréquence de résonance et la fréquence d'oscillation du résonateur 11 correspond à ce tirage. Par exemple, la fréquence d'oscillation dépendant (inversement proportionnelle) de la capacité de charge, le tirage est donc nul pour une capacité de charge infini. On comprend donc qu'en agissant sur ces capacités de charge, il est possible de modifier la fréquence d'oscillation de manière à compenser une éventuelle dérive thermique.

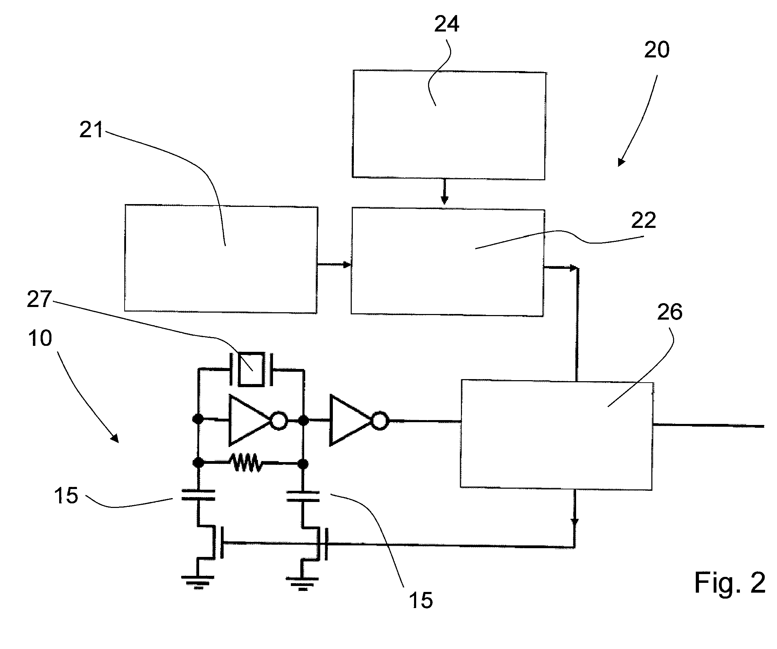

La figure 2 représente, selon un premier mode de réalisation de l'invention, un dispositif 20 apte à compenser la dérive en température d'une fréquence de référence d'un résonateur piézoélectrique de type silicium 27. Il comprend un capteur de température 21 relié à un séquenceur 22 pouvant être une machine d'états ou un microcontrôleur. Le capteur de température 21 peut être un transducteur capable de convertir une forme d'énergie en une autre forme qui peut être préférentiellement une mesure électrique. Une mémoire 24, directement reliée au séquenceur 22, permet de stocker des données de calibration. Le séquenceur 22 est directement connecté à un compteur variable 26 qui commande les capacités commutables 15 décrites à la figure 1. Le compteur variable 26 est typiquement un diviseur de fréquences variable c'est-à-dire que la valeur utilisée, par exemple un entier positif N, pour diviser une fréquence donnée, est paramétrable.

Le capteur de température 21 mesure une température de fonctionnement du circuit à intervalles définis et fournit un premier signal correspondant à la température mesurée. Le séquenceur 22 détermine un deuxième signal de compensation intégrant la valeur de la température, à partir du premier signal au moyen des données de calibration, le deuxième signal représentant la valeur N. De la même manière, le séquenceur 22 délivre un troisième signal représentant un rapport entre un entier positif S et l'entier N, S étant inférieur ou égal à N. Ce rapport correspond à un taux d'activité. Le compteur variable 26 est attaqué par le deuxième signal et le troisième signal. Le compteur 26 génère un quatrième signal de sortie, chaque N périodes d'un signal d'horloge provenant du résonateur 27. Ce compteur 26 joue le rôle d'un diviseur de fréquences qui produit un cycle chaque N périodes du signal reçu en entrée. Le quatrième signal correspond au signal de fréquence de référence compensée Fref. En outre, le compteur 26 possède une fonction supplémentaire, à savoir celle de détecter l'état S. Le compteur produit ainsi un cinquième signal apte à modifier la capacité de charge de l'oscillateur 10 pour produire un signal à fréquence haute ou basse. Ce cinquième signal produit une valeur qui change en fonction de la véracité de l'inégalité définie par l'état S inférieur ou égal à l'état N. Le taux d'activité peut ainsi être réglé. Ce taux d'activité correspond au temps moyen que l'oscillateur 10 passe en fréquence basse pendant N cycles du signal de l'oscillateur.

Les variations de fréquences du résonateur de type silicium 27 en fonction de la température peuvent faire l'objet d'une approximation par une fonction de type linéaire, la fonction pouvant également être d'ordre supérieur. Les paramètres de cette fonction peuvent être stockés dans la mémoire 24. La fonction peut être calculée par le séquenceur 22 en fonction du premier signal.

Le séquenceur 22 met également en fonctionnement le capteur de température aux intervalles définis. La valeur de la température peut, à titre d'exemple, correspondre à une valeur de tension électrique, elle-même convertie dans un format numérique au moyen d'un convertisseur analogique numérique. A l'aide des données de calibration, le séquenceur 22 va donc calculer une valeur de registre qui est appliquée sur le compteur variable 26 dans le but de changer le nombre de cycles à décompter en fonction de la valeur de température mesurée par le capteur. Il est typiquement utilisé un registre de 16 bits. Lorsque le taux d'activité sort d'un intervalle compris entre 0 et 1, le nombre de cycles à décompter change.

La variation relative linéarisée de la fréquence divisée, appelée df, en fonction d'un écart de température, noté $\Delta T$, de la valeur du taux de division N et de la valeur du taux d'activité, appelé dc, est définie par l'équation suivante :

$$df(\Delta T, N, dc) = \frac{\dfrac{f_o}{N} \cdot (1 + \alpha \cdot \Delta T + dc \cdot \Delta f_{HL}) - \dfrac{f_o}{N_o} \cdot (1 + dc_o \cdot \Delta f_{HL})}{\dfrac{f_o}{N_o} \cdot \left(1 + dc_o \cdot \Delta f_{HL}\right)} \quad (1)$$

où $\Delta f_{HL}$ correspond à l'écart de fréquence relatif entre la fréquence haute et basse, le coefficient $\alpha$ est le coefficient linéaire de variation de fréquence du résonateur en fonction de la température, No est le taux de division permettant de compenser les tolérances de fabrication à la température de calibration pour obtenir une fréquence de référence donnée et dco est le taux d'activité correspondant, i.e. défini par le rapport entre S et No.

[0021] La condition pour compenser la dérive linéaire du résonateur de type silicium est obtenue en annulant la variation relative de la fréquence. Cela correspond à l'équation suivante :

$$dc(\Delta T, N) = \frac{1}{\Delta f_{HL}} \left( \frac{N - N_o}{N_o} - \alpha \cdot \Delta T \right) + \frac{N}{N_o} \cdot dc_o \quad (2)$$

Il est alors obtenu le taux d'activité dc en fonction du taux de division N et l'écart de température $\Delta T$.

Le contrôle du dispositif objet de l'invention se fait de la manière suivante :

lorsque la valeur calculée du taux d'activité sort de l'intervalle admissible, i.e. entre 0 et 1, un ajustement du taux de division est alors commandé. Le taux d'activité est donc recentré. C'est le séquenceur 22 qui calcule la valeur N et le taux d'activité défini par le rapport entre S et N selon l'équation (2).

Dans une volonté d'optimiser l'intégration des divers composants électroniques, on peut prévoir d'intégrer sur un même substrat en matériau semi-conducteur tel que du silicium le capteur 21 et le résonateur 27. En effet, la technologie CMOS le permet. On peut également utiliser deux substrats différents. Ils seront ensuite assemblés par le procédé connu dit de « flip-chip » en s'assurant d'avoir le résonateur sous vide. Bien que les deux substrats soient différents, ils sont, de préférence, constitués du même matériau, typiquement du silicium, pour disposer de la même conductibilité thermique et éviter ainsi les gradients thermiques.

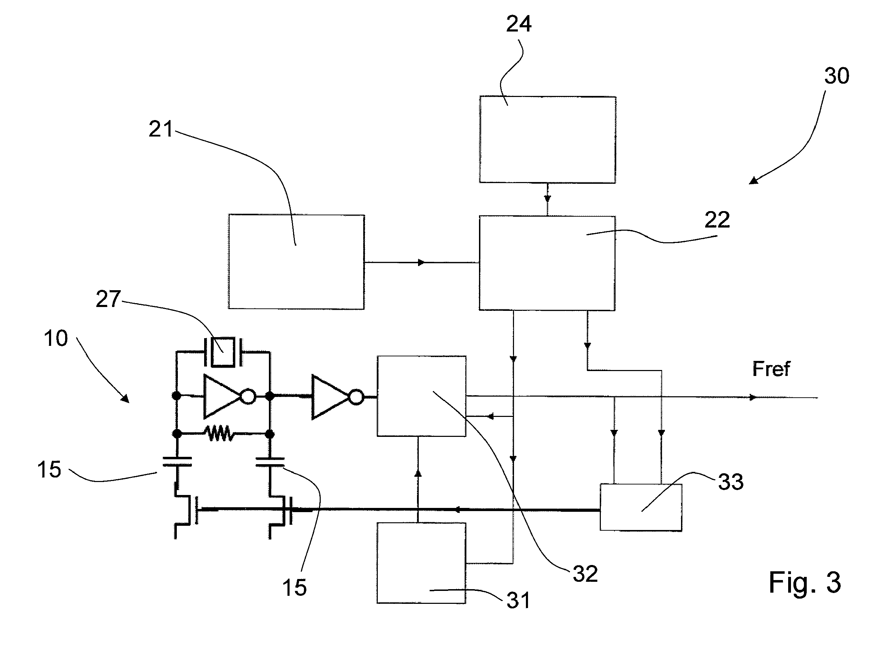

La figure 3 prévoit un deuxième mode de réalisation d'un dispositif de compensation en température d'une fréquence d'un résonateur de type silicium. A la différence du premier mode de réalisation présenté sur la figure 2 et dans lequel la fréquence compensée est générée directement par division entière, la seconde implémentation permet de générer par un dispositif 30, une fréquence compensée qui correspond à une puissance de deux multipliée par la fréquence compensée obtenue selon le premier mode de réalisation.

De manière comparable au dispositif 20 ci-dessus, ce dispositif 30 comprend le capteur de température 21 relié au séquenceur 22, et la mémoire 24 avec la même fonction que précédemment.

Le séquenceur 22 est relié à un accumulateur 31 et à un compteur bi-module 32. Les deux éléments 31 et 32 sont connectés entre eux. Le séquenceur 22 est en outre relié à un élément de comptage, pouvant être notamment un compteur fixe 33 ou un accumulateur de premier ordre ou d'ordre supérieur. Selon l'exemple, l'élément de comptage est un compteur fixe 33 divisant par M, dont un des signaux de sortie défini ci-après attaque les capacités commutées 15 de l'oscillateur 10.

A l'instar du dispositif 20, le séquenceur 22 détermine le deuxième signal représentant la valeur N qui, dans le cas du dispositif 30, n'est pas entière mais comporte une partie fractionnaire Nfrac. Un sixième signal correspondant à la partie fractionnaire Nfrac de N attaque l'accumulateur 31 qui a le même nombre de bits que Nfrac. Un septième signal correspondant à la partie entière Nint de N attaque le compteur bi-module 32. Lorsqu'il est plein (carry output ou retenue = 1), l'accumulateur commute le compteur bi-module à sa valeur supérieure (Nint+1) sans cependant mémoriser (accumuler) ce bit de commande. L'accumulateur 31 est typiquement un intégrateur discret borné.

Comme dans le premier mode de réalisation, le séquenceur délivre le troisième signal représentant le rapport entre S et M, S étant inférieur ou égal à M. Le compteur fixe 33 est attaqué par le troisième signal. Le compteur bi-module 32 génère le quatrième signal de sortie chaque Nint ou Nint+1 périodes du signal d'horloge provenant du résonateur 27. Ce signal correspond au signal de fréquence de référence compensée Fref défini ci-dessus selon le schéma de la figure 2, multiplié par $2^i$, i étant le nombre de bits de Nfrac. Il résulte que la fréquence moyenne du signal obtenu sur une période de Fref est rigoureusement égale à Fref. En outre, le compteur 33 possède une fonction supplémentaire, à savoir celle de détecter l'état S inférieur à la valeur fixe du compteur M. L'un des signaux de sortie mentionné ci-dessus est, comme dans le premier mode de réalisation, le cinquième signal apte à modifier la capacité de charge de l'oscillateur 10 pour produire un signal à fréquence haute ou basse. Ce type de compteur est typiquement un diviseur de fréquences, qui divise la valeur de la fréquence d'un signal d'entrée par une valeur prédéterminée fixe. Ce cinquième signal produit une valeur qui change en fonction de la véracité de l'inégalité définie par l'état S inférieur ou égal à l'état fixé par le compteur 33. Le taux d'activité entre la fréquence haute et la fréquence basse défini par le ratio entre S et M est ainsi contrôlé grâce à ce compteur 33.

A titre d'exemple numérique, il peut être généré par le premier mode de réalisation une fréquence de 32 Hz à partir du résonateur 27 de type silicium à 1 MHz. Cette fréquence étant très spécifique, il est avantageux d'utiliser la deuxième implémentation permettant de générer de manière exacte la fréquence moyenne d'un résonateur à quartz, à savoir 32768 Hz. En effet, étant donné que la fréquence exacte d'un résonateur à quartz est directement égale à $2^{10}$ fois 32 Hz, la valeur de division du compteur 33 peut être fixée à M=1024, c'est-à-dire $2^{10}$.

La solution proposée est donc compatible avec tout type de dispositif comportant habituellement un quartz horloger.

Bien entendu, la présente invention est susceptible de diverses variantes et modifications qui apparaîtront à l'homme de l'art. En particulier, il est à noter que d'autres types d'oscillateurs peuvent être associés à un résonateur piézoélectrique ou électrostatique de type silicium. A titre d'exemple non limitatif, il peut être cité le document EP 1 265 352 au nom de la demanderesse dans lequel est divulgué un oscillateur différentiel rentrant dans le cadre de l'invention telle que définie dans la présente demande. De plus, un mode bi-fréquence a été présenté dans la description. L'invention fonctionnerait également pour un oscillateur multifréquence.

**Revendications**

1. Dispositif apte à compenser la dérive en température d'une fréquence de référence d'un résonateur de type silicium (27) comprenant :

   - un capteur de température (21) apte à mesurer une température de fonctionnement dudit résonateur (27) et apte à fournir un premier signal correspondant à la température,
   - un séquenceur (22) relié audit capteur de température (21), ledit séquenceur (22) étant apte à déterminer un deuxième signal de compensation, à partir du premier signal et en fonction de la valeur de ladite température, au moyen de données de calibration destinées à être stockées dans un moyen de stockage (24) relié audit séquenceur (22), ledit deuxième signal correspondant à une valeur positive N, ledit séquenceur (22) étant, en outre, apte à déterminer un troisième signal de compensation, à partir dudit premier signal et en fonction de la valeur de ladite température, au moyen des données de calibration, ledit troisième signal correspondant à un rapport entre un entier positif S et N, S étant inférieur ou égal à N,

**caractérisé en ce que** ledit dispositif comprend un compteur variable (26) relié audit séquenceur (22) et relié à un oscillateur (10) muni dudit résonateur (27), ledit compteur variable (26) étant apte à recevoir lesdits signaux de compensation, apte à produire un quatrième signal de sortie chaque N périodes d'un signal d'horloge provenant dudit résonateur (27), et apte à détecter l'état S, agencé pour produire un cinquième signal apte à modifier la capacité de charge dudit oscillateur (10).

2. Dispositif selon la revendication 1, dans lequel N est un entier positif.

3. Dispositif selon la revendication 2, dans lequel ledit compteur variable (26) est un diviseur de fréquences variable apte à diviser la fréquence desdits signaux compensés par la valeur N.

4. Dispositif selon l'une des revendications 2 ou 3, dans lequel ledit séquenceur (22) est apte à déterminer ledit nombre entier positif N et un taux d'activité défini par le rapport entre S et N, en fonction de la valeur de température mesurée par ledit capteur de température (21).

5. Dispositif selon l'une des revendications 2 à 4, dans lequel ledit nombre N de cycles à décompter dudit deuxième signal est déterminé une fois ledit taux d'activité supérieur à 1.

6. Dispositif selon la revendication 1, dans lequel N comprend une partie entière Nint et une partie fractionnaire Nfrac, **caractérisé en ce que** ledit compteur variable (26) comprend :

   - un accumulateur (31) relié à la sortie du séquenceur (22) et apte à recevoir un sixième signal correspondant à la partie fractionnaire de N,
   - un compteur bi-module Nint, Nint+1 (32) relié à la sortie de l'accumulateur (31) et à la sortie du séquenceur (22), apte à recevoir un septième signal correspondant à la partie entière de N,
   - un élément de comptage (33) relié à la sortie du séquenceur (22) et à la sortie du compteur bi-module (32), apte à recevoir ledit troisième signal et ledit quatrième signal, ledit élément de comptage (33) étant apte à produire le cinquième signal en fonction de l'état S.

7. Dispositif selon l'une des revendications 1 à 6, dans lequel l'oscillateur est connecté à un banc de deux capacités (15) reliées chacune respectivement à un transistor (17).

8. Dispositif selon l'une des revendications 1 à 7, dans lequel ledit dispositif comprend un convertisseur analogique digital placé entre ledit capteur (21) et ledit séquenceur (22) et apte à convertir ladite température de fonctionnement en une tension numérique.

9. Dispositif selon l'une des revendications 1 à 8, dans lequel ledit séquenceur (22) est apte à mettre en fonctionnement ledit capteur de température (21) et apte à lire le signal correspondant à ladite température.

10. Dispositif selon l'une quelconque des revendications précédentes, dans lequel ledit capteur (21) et ledit résonateur (27) sont intégrés sur un même substrat de silicium.

11. Dispositif selon l'une quelconque des revendications précédentes, dans lequel ledit capteur (21) et ledit résonateur (27) sont intégrés respectivement chacun sur un substrat de silicium, lesdits deux substrats étant connectés par « flip-chip ».

12. Procédé de compensation de la dérive en température d'une fréquence de référence d'un résonateur piézoélectrique de type silicium (27) comprenant les étapes suivantes :

   - mise en fonctionnement d'un capteur de température (21) par un séquenceur (22) reliée audit capteur (21),
   - lecture d'un premier signal correspondant à une mesure de température de fonctionnement dudit résonateur (27), ledit premier signal étant issu du capteur de température (21),

**EP 2 101 413 A1**

- détermination d'un deuxième signal de compensation à partir dudit premier signal par le séquenceur (22) au moyen de données de calibration destinées à être stockées dans un moyen de stockage (24) relié audit séquenceur (22), ledit deuxième signal correspondant à une valeur positive N,

- détermination d'un troisième signal de compensation à partir dudit premier signal par le séquenceur (22) au moyen des données de calibration, ledit troisième signal correspondant à un rapport entre un entier positif S et N, S étant inférieur ou égal à N,

- réception desdits signaux compensés par un compteur variable (26) relié au séquenceur (22) et à un oscillateur (10) muni dudit résonateur (27),

- production d'un quatrième signal de sortie par le compteur variable (26) chaque N périodes d'un signal d'horloge provenant dudit résonateur (27),

- détection de l'état S inférieur ou égal à N, dans le but de produire un cinquième signal apte à modifier la capacité de charge dudit oscillateur (10).

**13.** Procédé selon la revendication 12, dans lequel N est un entier positif.

**14.** Procédé selon la revendication 12, dans lequel N comprend une partie entière Nint et une partie fractionnaire Nfrac, **caractérisé en ce que** ledit compteur variable (26) comprend :

- un accumulateur (31) relié à la sortie du séquenceur (22) et apte à recevoir un sixième signal correspondant à la partie fractionnaire de N,

- un compteur bi-module Nint, Nint+1 (32) relié à la sortie de l'accumulateur (31) et à la sortie du séquenceur (22), apte à recevoir un septième signal correspondant à la partie entière de N,

- un élément de comptage (33) relié à la sortie du séquenceur (22) et à la sortie du compteur bi-module (32), apte à recevoir ledit troisième signal et ledit quatrième signal, ledit compteur fixe (33) étant apte à détecter l'état S et à produire le cinquième signal en fonction de l'état S.

7

Fig. 1

Fig. 2

EP 2 101 413 A1

Fig. 3

**Office européen**

**des brevets**

**RAPPORT DE RECHERCHE EUROPEENNE**

Numéro de la demande

EP 08 15 2548

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (IPC) |
| Y | JP 58 173488 A (SEIKO INSTR & ELECTRONICS) 12 octobre 1983 (1983-10-12) * le document en entier * | 1-14 | INV. H03L1/02 |
| Y | EP 1 475 885 A (CITIZEN WATCH CO LTD [JP] CITIZEN HOLDINGS CO LTD [JP]) 10 novembre 2004 (2004-11-10) * alinéa [0069] - alinéa [0099] * | 1-14 | |
| D,A | LANFRANCHI D ET AL: "A microprocessor-based analog wristwatch chip with 3 seconds/year accuracy" SOLID-STATE CIRCUITS CONFERENCE, 1994. DIGEST OF TECHNICAL PAPERS. 41S T ISSCC., 1994 IEEE INTERNATIONAL SAN FRANCISCO, CA, USA 16-18 FEB. 1994, NEW YORK, NY, USA,IEEE, 16 février 1994 (1994-02-16), pages 92-93, XP010121053 ISBN: 978-0-7803-1844-1 * le document en entier * | 1-14 | |
| Y | EP 1 304 804 A (ST MICROELECTRONICS PVT LTD [IN]) 23 avril 2003 (2003-04-23) * le document en entier * | 1,6,12, 14 | DOMAINES TECHNIQUES RECHERCHES (IPC) H03L H03K |
| A | JP 59 105720 A (NIPPON ELECTRIC CO) 19 juin 1984 (1984-06-19) * le document en entier * | 1,8 | |
| A | US 2005/151592 A1 (PARTRIDGE AARON [US] ET AL) 14 juillet 2005 (2005-07-14) * alinéas [0085], [0108]; figures 15,17c * | 1,10,11 | |

Le présent rapport a été établi pour toutes les revendications

| Lieu de la recherche | Date d'achèvement de la recherche | Examinateur |
|---|---|---|
| La Haye | 16 septembre 2008 | Jepsen, John |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 08 15 2548

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-09-2008

| Document brevet cité au rapport de recherche | | | Date de publication | Membre(s) de la famille de brevet(s) | | Date de publication |
|---|---|---|---|---|---|---|
| JP 58173488 | A | | 12-10-1983 | AUCUN | | |
| EP 1475885 | A | | 10-11-2004 | CN | 1618166 A | 18-05-2005 |
| | | | | WO | 03063335 A1 | 31-07-2003 |
| | | | | JP | 3973910 B2 | 12-09-2007 |
| | | | | JP | 2003218636 A | 31-07-2003 |
| | | | | TW | 281312 B | 11-05-2007 |
| | | | | US | 2005040904 A1 | 24-02-2005 |
| | | | | US | 2007030084 A1 | 08-02-2007 |
| EP 1304804 | A | | 23-04-2003 | US | 2003076137 A1 | 24-04-2003 |
| JP 59105720 | A | | 19-06-1984 | AUCUN | | |
| US 2005151592 | A1 | | 14-07-2005 | CN | 1902824 A | 24-01-2007 |
| | | | | EP | 1706942 A2 | 04-10-2006 |
| | | | | JP | 2007518351 T | 05-07-2007 |
| | | | | KR | 20060123450 A | 01-12-2006 |
| | | | | US | 2006022764 A1 | 02-02-2006 |
| | | | | US | 2006033589 A1 | 16-02-2006 |
| | | | | US | 2008164953 A1 | 10-07-2008 |
| | | | | WO | 2005071842 A2 | 04-08-2005 |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1265352 A

**Littérature non-brevet citée dans la description**

- **D. Lanfranchi et al.** A Microprocessor-Based Analog Wristwatch Chip with 3 Seconds/Year Accuracy. *IEEE,* 1994